Europäisches Patentamt

European Patent Office

Office européen des brevets

(11) Veröffentlichungsnummer: **0 186 829 B1**

(12) **EUROPÄISCHE PATENTSCHRIFT**

(45) Veröffentlichungstag der Patentschrift: 07.08.91

(51) Int. Cl.5: **H01L 21/60, H01L 23/48**

(21) Anmeldenummer: **85115865.9**

(22) Anmeldetag: **12.12.85**

(54) **Verfahren und Verbindungswerkstoff zum metallischen Verbinden von Bauteilen.**

(30) Priorität: **21.12.84 DE 3446780**

(43) Veröffentlichungstag der Anmeldung:
**09.07.86 Patentblatt 86/28**

(45) Bekanntmachung des Hinweises auf die
Patenterteilung:
**07.08.91 Patentblatt 91/32**

(84) Benannte Vertragsstaaten:
**AT BE CH FR GB IT LI NL SE**

(56) Entgegenhaltungen:
**EP-A- 0 164 537**
**DE-A- 1 514 078**
**FR-A- 2 235 752**
**US-A- 3 919 709**

**IBM TECHNICAL DISCLOSURE BULLETIN,
Band 24, Nr. 12, März 1982, Seiten 6430-6431,
IBM, New York, US; W.R. MILLER et al.: "Disc
preform for braze joining pins to substrates"**

(73) Patentinhaber: **Asea Brown Boveri Aktiengesellschaft**
**Kallstadter Strasse 1**
**W-6800 Mannheim-Käfertal(DE)**

(72) Erfinder: **Jahnke, Bernd, Dr. Dipl.-Phys.**
**Adalbert-Seifriz-Strasse 10**
**W-6903 Neckargemünd(DE)**
Erfinder: **Ingram, Peter, Dipl.-Chem.**
**Wilhelm-Trübner-Strasse 13**
**W-6944 Hemsbach(DE)**
Erfinder: **Neidig, Arno, Dr. Dipl.-Phys.**
**Brühlerweg 42**
**W-6831 Plankstadt(DE)**

(74) Vertreter: **Rupprecht, Klaus, Dipl.-Ing. et al**
**c/o Asea Brown Boveri Aktiengesellschaft**
**Zentralbereich Patente Postfach 100351**
**W-6800 Mannheim 1(DE)**

## Beschreibung

Die Erfindung bezieht sich auf ein Verfahren zum metallischen Verbinden von Bauteilen gemäß dem Oberbegriff des Patentanspruches 1 sowie auf einen Verbindungswerkstoff zur Durchführung des Verfahrens.

Ein solches Verfahren kommt vorzugsweise bei der Verbindung von Halbleiterbauelementen und Substraten zur Anwendung.

Es sind bereits eine Vielzahl von Verbindungswerkstoffen, insbesondere Weichlotmaterialien bekannt, mit denen Halbleiterbauelemente untereinander oder selbige mit ihren Substraten oder sonstigen Bauelementen bei einer Temperatur von 180 bis 350 ° C verbunden werden. Obwohl das Weichlöten den wesentlichen Vorteil aufweist, daß es eine hohe Integrierbarkeit gegenüber dem sogenannten Druckkontakt aufweist, ergeben sich bei Leistungshalbleitern mit Dauergrenzströmen über 100 A Probleme aufgrund der geringen Wechsellastfestigkeit der Verbindung. Starke unterschiedliche thermische Ausdehnungskoeffizienten der verwendeten Materialien z. B. Silizium, Keramik, Kupfer führen unter Beanspruchung zu plastischen Verformungen, die ungünstige Gefügeveränderungen im erstarrten Lotwerkstoff erzeugen. Poren und Lunker, die sich bei Erstarrung des Lotes vor allem bei unzureichender Benetzung des Lotes mit den zu verbindenden Partnern bilden können, beschleunigen die Ausfälle. Darüber hinaus bilden sich aufgrund des großen Angebots flüssigen Lotes (~ 0,1 mm Lot) an den Grenzflächen der zu verbindenden Bauteile (z. B. Kupfer oder die Metallisierungsschichten der Halbleiteraktivelemente wie z. B. CrNiAg) spröde Phasen, die die Festigkeit stark vermindern können.

Aus der US-A-3919709 ist ein Verfahren zum metallischen Verbinden von Bauteilen bekannt. Hierfür wird zwischen die zu verbindenden Bauteile ein mehrschichtiger Verbundwerkstoff angeordnet. Anschließend werden die Bauteile unter Einwirkung von Wärme miteinander verbunden, wobei die Oberflächenschichten des Verbundwerkstoffs angelöst werden. Der verwendete metallische Verbindungswerkstoff kann durch eine metallische Folie gebildet werden, die den Kern bildet und beidseitig mit einer metallischen Oberflächenschicht überzogen ist.

Der Erfindung liegt die Aufgabe zugrunde ein Verfahren und einen Verbindungswerkstoff aufzuzeigen mit dem Bauteile in Form von metallisierten Halbleiterbauelementen und metallische Bauelemente sowie metallisierte Substrate miteinander dauerhaft und funktionsfähig verbunden werden können.

Diese Aufgabe wird erfindungsgemäß durch die kennzeichnenden Merkmale des Patentanspruches 1 gelöst.

Ein für die Durchführung des Verfahrens geeigneter Verbindungswerkstoff ist in Patentanspruch 6 offenbart.

Bei dem erfindungsgemäßen Lötverfahren wird in den Fügebereich ein mehrschichtiger Verbundwerkstoff eingebracht, der thermisch, mechanisch und korrosiv belastbar ist. Der Verbindungswerkstoff weist eine metallische oberste Schicht auf, die mit einem dünnen Bereich von etwa 1 bis 5 $\mu$m der Kernschicht bei der Löttemperatur eine flüssige, zumindest aber sehr leicht verformbare Lötschicht bildet. Der Verbindungswerkstoff geht mit den zu verbindenden Bauteilen eine feste Verbindung ein. Erfindungsgemäß wird ein Verbindungswerkstoff verwendet, der aus mindestens drei Schichten aufgebaut ist. Die Kernschicht besteht aus Blei oder einer Legierung aus Zinn und/oder Antimon mit Silber. In jedem Fall muß das Material so beschaffen sind, daß es die geforderte Wechsellastfestigkeit bzw. die gewünschte Zeitstandsfestigkeit aufweist. Die Kernschicht sollte eine Dicke von 20 bis 60 $\mu$m aufweisen. Die den Bauteilen zugewandten Oberflächen dieser Kernschicht sind mit je einer Oberflächenschicht überzogen, die eine Dicke zwischen 0,5 und 2 $\mu$m besitzt, und mit der Kernschicht ein niederschmelzenden Eutektikum bildet, wie z. B. Zinn. Werden mit dem erfindungsgemäßen Verfahren Halbleiterbauelemente bzw. Halbleiterbauelemente und metallische Bauelemente miteinander verbunden, so sind die Halbleiterbauelemente auf ihrer dem Verbindungswerkstoff zugewandten Seite mit einer Metallisierung versehen, die vorzugsweise durch eine Legierung aus Aluminium - Chrom - Nickel und Silber bzw. einer Nickel-Silber-Legierung gebildet wird. Hierdurch wird eine optimale Verbindung zwischen der Oberflächenschicht aus Zinn und dem Halbleiterbauelement geschaffen. Die Dicke der für die Durchführung des Verfahrens verwendeten Oberflächenschicht wird auf die miteinander zu verbindenden Bauteile so abgestimmt, daß der flüssigwerdende Bereich bei der Löttemperatur, insbesondere einer Temperatur zwischen 180 und 350 ° C, aufgrund von Diffussionsprozessen zunächst weitgehend isotherm erstarrt. Wird eine Blei Kernschicht, wie oben beschrieben, verwendet, bildet sie mit den beiden auf sie aufgetragenen Zinnschichten in einem schmalen Bereich ein Blei-Zinn-Eutektikum aus, mit dem der eigentliche Lötprozeß erfolgt. Aufgrund der geringen Zinnkonzentration während der Aufmischung sowie der Abdiffussion kommt es nach kurzer Zeit zu der isothermen Erstarrung. Das günstige Gefüge der aus Blei gefertigten Kernschicht bleibt weitgehend erhalten, da sie bis auf eine Randzone von etwa 2 bis 5 $\mu$m nicht aufschmilzt. Aufgrund der geringen Legierungskonzentration in der aufgeschmolzenen "Lotzone" treten nur wenige Sprödphasen auf. Bei dem erfindungsgemäßen Verfahren besteht die Möglichkeit, den für die Durchführung des Lötverfahrens verwendeten Verbindungswerkstoff optimal an die zu verbindenden Bauteile anzupassen, so daß das Auftreten von Benetzungsproblemen unterbunden werden kann. Erfolgt das Verbinden unter Anwendung von Wärme und gleichzeitiger Druckanwendung, so kann ggf. bei leicht reibförmiger Bewegung auf ein Aufschmelzen der Randzone ganz verzichtet werden. In diesem Fall handelt es sich um Festkörperschweißverbindungen, wobei die Oberflächenschicht des Verbindungswerkstoffs wie z. B. Zinn plastisch verformbar ist, und durch ausreichende Annäherung der zu verbindenden Partner im atomaren Bereich metallische Bindung auftritt.

Weitere erfindungswesentliche Merkmale sind in den Unteransprüchen gekennzeichnet.

Das erfindungsgemäße Verfahren wird nachfolgend anhand eines Ausführungsbeispielen erläutert.

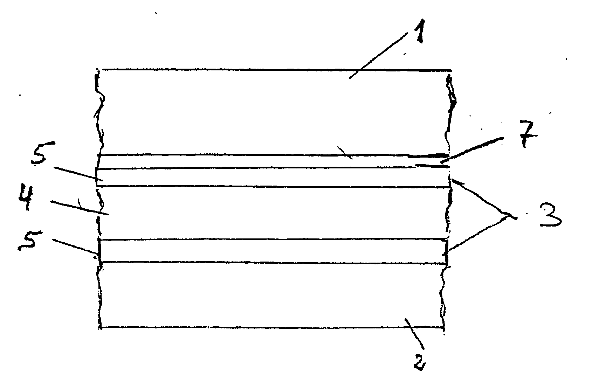

Die einzige Figur zeigt ein Halbleiterbauelement 1, das unter Anwendung des erfindungsgemäßen Verfahrens mit einem metallischen Bauelement 2 verbunden ist. Das Halbleiterbauelement 1 ist auf seiner dem Bauelement 2 zugewandten Seite mit einer Metallisierung 7 versehen, die bei dem hier dargestellten Ausführungsbeispiel durch eine Aluminium, Chrom, Nickel, Silberlegierung gebildet ist. Es besteht die Möglichkeit die Metallisierung unter anderem auch durch eine Nickel-Silber-Verbindung oder eine andere Schicht zu bilden. Das mit dem Halbleiterbauelement 1 zu verbindende metallische Bauelement ist aus Molybdän gefertigt. Bauelemente, aus anderen metallischen Werkstoffen gleichgültig welcher Art, können ebenfalls mit dem erfindungsgemäßen Verfahren mit einem Halbleiterbauelement verbunden werden, sofern die Ausdehnungskoeffizienten diese Kombination zulassen. Für die Durchführung des Verfahrens wird zwischen die zu verbindenden Bauelemente 1 und 2 ein mehrschichtiger metallischer Verbindungswerkstoff 3 angeordnet. Dieser weist eine Kernschicht 4 auf, die bei dem hier dargestellten Ausführungsbeispiel aus Blei besteht. Sie weist eine Dicke zwischen 20 bis 60 $\mu$m auf. Anstelle einer Kernschicht 4 aus Blei kann auch eine Kernschicht verwendet werden, die aus einer Zinn, Antimon, Silber-Legierung gefertigt ist. Es besteht die Möglichkeit, anstelle dieser oben erwähnten Materialien auch andere Werkstoffe zur Ausbildung der Kernschicht 4 zu verwenden. Diese Werkstoffe müssen lediglich die geforderten Bedingungen erfüllen, insbesondere die gewünschte Wechsellastfestigkeit und/oder Zeitstandsfestigkeit aufweisen.

Auf die beiden den Bauelementen 1 und 2 zugewandten Flächen dieser Kernschicht 4 ist jeweils eine Oberflächenschicht 5 aus Zinn aufgetragen. Die beiden Oberflächenschichten 5 weisen eine Dicke von 0,5 bis 2 $\mu$m auf. Nachdem dieser Verbindungswerkstoff 3 zwischen den beiden Bauelementen 1 und 2 angeordnet ist, erfolgt das eigentliche Verlöten des Halbleiterbauelementes 1 mit dem metallischen Bauelement 2. Hierfür wird die in der Figur dargestellte Anordnung auf eine Temperatur von 180 bis 350 °C aufgeheizt. Die Ausübung einer Druckkraft auf die beiden Bauelemente kann für eine optimale Verbindung sehr förderlich sein. Zu diesem Zweck wird gegen die nach außen gerichtete Begrenzungsfläche des Halbleiterbauelementes 1 und des metallischen Bauelementes 2 je ein Preßstempel (hier nicht dargestellt) gedrückt. Unter der Einwirkung der oben angegebenen Wärme und dieser Druckkraft kommt es zum Aufschmelzen der beiden Oberflächenschichten 5. Die Kernschicht 4 wird nur in einer sehr dünnen Randzone aufgeschmolzen. Die Tiefe dieser aufgeschmolzenen Randzone beträgt bei der Kernschicht 1 bis 5 $\mu$m. Ist die Kernschicht aus reinem Blei gefertigt, so kommt es in dieser schmalen Randzone zur Ausbildung eines Blei-Zinn-Eutektikums, mit dem der eigentliche Lötprozess erfolgt. Aufgrund der geringen Zinnkonzentration während der Aufmischung bzw. der Abdiffussion kommt es nach kurzer Zeit zu einer isothermischen Erstarrung, da Blei in den Zinnbereich und umgekehrt diffundiert und somit der Liquidus- bzw. Soliduspunkt der sich ergebenden Legierung erhöht wird. Das Gefüge der aus Blei gefertigten Kernschicht bleibt im wesentlichen erhalten.

Auf das Aufschmelzen des Lotes kann auch verzichtet werden. Der prinzipielle Schicht- und Verbindungsaufbau bleibt dann auch hierbei mit dem in der Abbildung identisch. Die Kernschicht 4 besteht wiederum aus Blei oder einer Bleilegierung oder einer Silber-Zinn-Antimon-Legierung. Die beidseitige Beschichtung 5 besteht aus einer leicht plastisch verformbaren dünnen Schicht aus Blei-Zinn, oder Blei-Silber oder reinem Zinn je nach Temperatureinsatz mit einer Dicke von 1 bis 5 $\mu$m.

Der Fügeprozeß der Komponenten 1 und 2 mit der Verbundzwischenschicht 3 ist ein reiner Festkörperdiffusionsschweißprozeß. Er kann durch Ultraschall-Reibschweißen unter Temperatureinwirkung erfolgen (Thermosonic-bonden, oder ausschließlich unter Temperatureinwirkung und Druck (Thermokompressionsschweißen).

## Patentansprüche

1. Verfahren zur metallischen Verbindung von Bauteilen, die durch Halbleiter-Bauelemente (1) mit wenigstens einseitiger Metallisierung oder durch metallische Bauelemente bzw. metallische Substrate (2) gebildet werden, wobei zwischen die zu verbindenden Bauteile (1,2) ein mehrschichtiger Verbundwerkstoff (3) angeordnet wird und die Bauteile (1,2) unter Einwirkung von Wärme und einem Anlösen der Oberflächenschichten (5) des Verbundwerkstoffs (3) verbunden werden, dadurch gekennzeichnet, daß der thermisch, mechanisch und korrosiv belastbare Verbundwerkstoff (3) eine metallische Kernschicht (4) enthält, die eine definierte Zeitzustandsfestigkeit und/oder Wechsellastfestigkeit aufweist, und auf die beidseitig eine den Schmelzpunkt der Kernschicht senkende metallische Oberflächenschicht (5) aufgetragen wird, welche in einem 1 bis 5 μm dicken Randbereich der Kernschicht (4) mit dieser ein niedriger schmelzendes Eutektikum bildet oder ein Festkörperdiffusionsschweißprozeß ermöglicht insofern die Beidseitige Beschichtung (5) leicht plastisch verformbar ist.

2. Verfahren nach Anspruch 1, dadurch gekennzeichnet, daß zwischen den Bauteilen (1,2) ein Verbundwerkstoff (3) mit einer Kernschicht (4) aus Blei, einer Bleilegierung oder einer Zinn, Antimon, Silber-legierung, angeordnet wird, die beidseitig mit einer Oberflächenschicht aus Zinn, Blei-Zinn oder Blei-Silber überzogen wird.

3. Verfahren nach einem der Ansprüche 1 oder 2, dadurch gekennzeichnet, daß der zwischen den Bauteilen (1,2) angeordnete Verbundwerkstoff (3) eine Kernschicht (4) mit einer Dicke von 20 bis 60 μm aufweist, auf die beidseitig jeweils eine Oberflächenschicht (5) aufgetragen wird, die eine Dicke zwichen 0,5 und 2 μm aufweist.

4. Verfahren nach einem der Ansprüche 1 bis 3, dadurch gekennzeichnet, daß die Bauteile (1,2) bei einer Temperatur von 180 bis 350° C unter Zwischenfügen des Verbundwerkstoffs (3) miteinander verlötet werden.

5. Verfahren nach einem der Ansprüche 1 bis 3, dadurch gekennzeichnet, daß die Bauteile (1,2) mit dem Verbundwerkstoff (3) über ein Festkörper-Diffusionsschweißverfahren gefügt werden, bei dem es sich um ein Thermokompressionsbonden oder ein Thermosonicbonden handelt.

6. Metallischer Verbindungswerkstoff zur Durchführung des Verfahren nach Anspruch 1, dadurch gekennzeichnet, daß die Kernschicht (4) als 20 bis 60 μm dicke Folie aus Blei, einer Bleilegierung oder einer Zinn, Antimon, Silberlegierung ausgebildet ist und beidseitig mit einer 0,5 bis 2 μm dicke Oberflächenschicht (5) aus Zinn, Blei-Zinn, oder Blei-Silber überzogen ist.

## Claims

1. Process for metallically joining components which are formed by semiconductor devices (1) having at least single-sided metallisation or by metallic components or metallic substrates (2), in which a multilayer composite material (3) is arranged between the components to be joined (1, 2) and the components (1, 2) are joined by exposure to heat and an incipient dissolution of the surface layers (5) of the composite material (3), characterised in that the thermally, mechanically and corrosively loadable composite material (3) contains a metallic core layer (4) which has a defined time condition strength [sic] and/or resistance to change in load and on both sides of which there is deposited a metallic surface layer (5) which lowers the melting point of the core layer and which forms, in a 1 to 5 μm thick peripheral region of the core layer (4) a low-melting eutectic with the latter or makes possible a solid-state diffusion welding process provided the double-sided coating (5) is easily plastically deformable.

2. Process according to Claim 1, characterised in that there is arranged between the components (1, 2) a composite material (3) having a core layer (4) which is composed of lead, of a lead alloy or of a tin, antimony, silver alloy and which is coated on both sides with a surface layer of tin, lead/tin or lead/silver.

3. Process according to either of Claims 1 or 2, characterised in that the composite material (3) disposed between the components (1, 2) has a core layer (4) which has a thickness of 20 to 60 μm and on both sides of which there is deposited in each case a surface layer (5) which has a thickness of between 0.5 and 2 μm.

4. Process according to any of Claims 1 to 3, characterised in that the components (1, 2) are soldered to one another at a temperature of 180 to 350° C with the interposition of the composite material (3).

5. Process according to any of Claims 1 to 3, characterised in that the components (1, 2) are joined by means of the composite material (3) using a solid-state diffusion welding process in which a thermocompression bonding or a thermosonic bonding is involved.

6. Metallic joining material for carrying out the process according to Claim 1, characterised in that the core layer (4) is formed as 20 to 60 $\mu$m thick foil of lead, a lead alloy or a tin, antimony, silver alloy and is coated on both sides with a 0.5 to 2 $\mu$m thick surface layer (5) of tin, lead/tin or lead/silver.

**Revendications**

1. Procédé pour relier par voie métallique des composants, qui sont formés par des composants à semi-conducteurs (1) avec au moins une métallisation sur une face ou par des composants métalliques ou des substrats métalliques (2), un matériau composite (3) à plusieurs couches étant placé entre les composants (1, 2) à relier et les composants (1, 2) étant reliés sous l'action de la chaleur et par fusion des couches superficielles (5) du matériau composite (3), caractérisé en ce que le matériau composite (3) pouvant être soumis à une action thermique, mécanique et corrosive, comporte une couche centrale (4) métallique, présentant une résistance à la rupture et/ou une résistance aux charges ondulées données, sur laquelle est applqiuée de chaque côté une couche superficielle (5) métallique abaissant le point de fusion, qui forme avec la couche centrale (4) dans une zone périphérique de celle-ci, d'une épaisseur comprise entre 1 et 5 $\mu$m, un eutectique à faible point de fusion ou permet l'application d'un procédé de soudure par diffusion solide, dans la mesure où le revêtement (5) sur les deux faces peut subir facilement une déformation plastique.

2. Procédé selon la revendication 1, caractérisé en ce qu'un matériau composite (3) comportant une couche centrale (4) de plomb, d'un alliage à base de plomb, ou d'un alliage étain, antimoine, argent, qui est recouverte sur les deux faces d'une couche superficielle d'étain, de plomb-étain ou de plomb-argent, est placé entre les composants (1, 2).

3. Procédé selon l'une des revendications 1 ou 2, caractérisé en ce que le matériau composite placé entre les composants (1, 2) comporte une couche centrale (4) d'une épaisseur comprise entre 20 et 60 $\mu$m, recouverte sur les deux faces d'une couche superficielle (5) dont l'épaisseur est comprise entre 0,5 et 2 $\mu$m.

4. Procédé selon l'une des revendications 1 à 3, caractérisé en ce que les composants (1, 2) sont soudés entre eux à une température comprise entre 180 et 350° C avec interposition du matériau composite (3).

5. Procédé selon l'une des revendications 1 à 3, caractérisé en ce que les composants (1, 2) sont assemblés à l'aide du matériau composite (3) par un procédé de soudage par diffusion solide, qui est un bonding par thermocompression ou un bonding thermosonique.

6. Matériau de liaison mécanique pour la mise en oeuvre du procédé selon la revendication 1, caractérisé en ce que la couche centrale (4) est formée par un film de 20 à 60 $\mu$m d'épaisseur de plomb, d'un alliage à base de plomb, ou d'un alliage étain, antimoine, argent, et est recouverte sur les deux faces d'une couche superficielle (5) de 0,5 à 2 $\mu$m d'épaisseur d'étain, de plomb-étain ou de plomb-argent.

EP 0 186 829 B1

6